# EUROPEAN PATENT SPECIFICATION

(11) **EP 3 533 087 B1**
(45) Date of publication and mention of the grant of the patent: **12.08.2020**
(21) Application number: 17794929.4
(22) Date of filing: 24.10.2017
(51) Int. Cl.: H01L 31/048

(54) **PHOTOVOLTAIC PANEL HAVING A FLEXIBLE STRUCTURE AND METHOD OF MANUFACTURING.**
FOTOVOLTAIKPANEEL MIT FLEXIBLER STRUKTUR UND VERFAHREN ZUR HERSTELLUNG
PANNEAU PHOTOVOLTAÏQUE AYANT UNE STRUCTURE FLEXIBLE ET PROCÉDÉ DE FABRICATION

(30) Priority: 25.10.2016 IT 201600107594
(43) Date of publication of application: 04.09.2019
(73) Proprietor: Agatos Energia S.r.l., 20156 Milano (IT)
(72) Inventor: MORISCO, Federico, I-20127 Milano (MI) (IT)
(74) Representative: De Bortoli, Eros
(86) International application number: PCT/EP2017/077116
(87) International publication number: WO 2018/077849

(56) References cited:
- WO-A1-2013/140578
- US-A- 4 713 492
- US-A1- 2016 118 932

## Description

The present invention relates to a photovoltaic panel having improved characteristics, particularly suitable for installation on roofs, civil and industrial roofing in general, tensile structures, agricultural or maritime installations, and similar. The document US20160118932A is a related prior art.

As is known, a photovoltaic panel typically has a flat, rigid structure with a considerable size and weight (e.g. around 20 kg for a panel measuring 90x160x5 cm).

A traditional installation method for a photovoltaic panel involves the use of a supporting frame arranged to provide adequate mechanical support and to orient the actual panel.

Installation solutions of this type, although much appreciated since they make it possible to optimize exposure of the photovoltaic panels to sunlight regardless of the inclination of the roofing on which they are placed, do have several drawbacks.

In an urban setting, the placing of panels on many types of roofing that are theoretically available may be made difficult, if not impossible, by the excessive size and weight involved.

Furthermore, still as a result of the considerable size of the photovoltaic panels and their supporting frames, these installation solutions often create a significant visual impact, which can make it problematic to place them in valued urban settings, such as old town centres.

Another known installation method for a photovoltaic panel involves laying the panel on a supporting surface (e.g. civil or industrial roofing), following the orientation of the roofing.

Installation solutions of this type have the undoubted advantage or requiring very simple mechanical support structures that are considerably lighter than those described above. Their installation in an urban setting is therefore much easier and has a less marked visual impact.

These solutions, however, often do not make it possible to obtain the best possible production of electrical energy from the photovoltaic panels since the orientation of the panel supporting surface is not always ideal.

Furthermore, and something that constitutes a significant drawback, the positioning of the panel on a compact supporting surface can make cooling the photovoltaic modules during operation problematic. Indeed, the smaller gaps between the photovoltaic panel and the relative supporting surface do not allow adequate air circulation over the lower surface of the panel, thus limiting the heat exchange between the photovoltaic cells and the external atmosphere, thereby causing them to overheat, with a consequent reduction in the efficiency of photovoltaic conversion.

The main aim of the present invention is to provide a photovoltaic panel that makes it possible to overcome the drawbacks described above.

In the context of this aim, an object of the present invention is to provide a photovoltaic panel easy to install and has a low visual impact. The object of the invention is as recited in the set of claims on file.

Another object of the present invention is to provide a photovoltaic panel having considerable flexibility of use, for example that can be easily placed on any civil or industrial roofing or, more generally, on diversified installation structures, including tensile structures or vertical walls.

A further object of the present invention is to provide a photovoltaic panel particularly light and relatively small in size, particularly in terms of weight.

Not the last object of the present invention is to provide a photovoltaic panel relatively easy to manufacture at competitive costs.

This aim and these objects, together with other objects that will become more apparent from the following description and from the accompanying drawings, are achieved according to the invention, by a photovoltaic panel according to claim 1 and to the related dependent claims.

In a further aspect, the present invention also relates to a method for the manufacture of a photovoltaic panel, according to claim 10 below and to the related dependent claims.

In a general definition, the photovoltaic panel, according to the invention, comprises a plurality of photovoltaic modules adapted to provide electric power when illuminated by a light radiation on at least a surface. Said photovoltaic modules are mutually spaced one from another according to horizontal and vertical directions.

The photovoltaic panel further comprises one or more conductive elements for the electrical connection of said photovoltaic modules and a support and protection structure for said photovoltaic modules and said conductive elements.

Said support and protection structure comprises a plurality of encapsulation portions, at which said photovoltaic modules are arranged, and one or more connection portions adapted to connect said encapsulation portions one with another.

Said connection portions being flexible so that said support and protection structure is foldable at said connection portions according to at least two mutually perpendicular axes, preferably along at least a horizontal axis and at least a vertical axis.

According to an aspect of the invention, said support and protection structure is made, at least partially, of a polymeric material.

Preferably, said support and protection structure is obtained by obtaining a semi-finished product having a plurality of overlapped layers of polymeric material and by carrying out a hot rolling mill process on said semi-finished product.

According to the invention, said support and protection structure is made, at least partially, of material transparent to said light radiation.

According to the invention, said support and protection structure is covered with holes at said connection portions.

According to the invention, said support and protection structure comprises one or more anchoring portions at which said support and protection structure is connectable with an installation structure or with the support and protection structure of a further photovoltaic panel.

According to the invention, said support and protection structure comprises a plurality of protection elements made of material transparent to said light radiation. Each protection element is operatively associated with a respective photovoltaic module at a surface of said photovoltaic module.

According to the invention, said support and protection structure comprises:
- a first protection layer;
- a first encapsulation layer bonded to said first protection layer. Said first encapsulation layer covers said photovoltaic modules at a first surface of said photovoltaic modules;
- a second protection layer bonded to said first encapsulation layer at the connection portions of said support and protection structure. Said second protection layer comprises a plurality of mutually spaced apertures. Each aperture is positioned at a second surface of a respective photovoltaic module, which is opposed to said first surface;
- a second encapsulation layer comprising a plurality of mutually spaced portions. Each portion is arranged at a respective aperture of said second protection layer to cover a respective photovoltaic module at said second surface.

According to the invention, each protection element of the support and protection structure is arranged to cover a corresponding portion of said second encapsulation layer at the second surface of a respective photovoltaic module.

According to the invention, the conductive elements of the photovoltaic panels comprise first flexible portions arranged at respective connection portions of said support and protection structure to favor the folding of said support and protection structure at said respective connection portions.

According to the invention, the photovoltaic panel comprises mechanical connection means adapted to connect said support and protection structure with an installation structure or a further photovoltaic panel.

Further characteristics and advantages of the present invention will become more apparent with reference to the description given below and to the accompanying figures, provided purely for explanatory and non-limiting purposes, wherein:
- figure 1 schematically shows the photovoltaic panel according to the invention, in a preferred embodiment thereof;

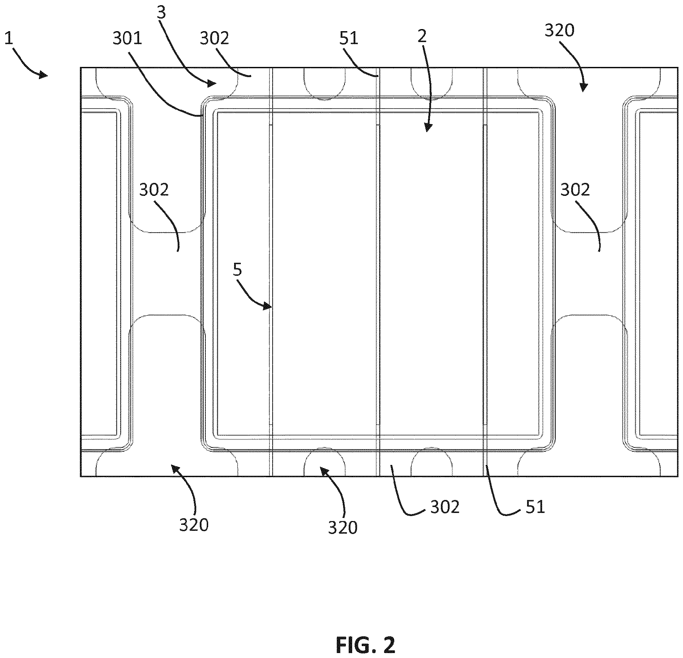

- figure 2 schematically shows in enlarged form a portion of the photovoltaic panel shown in figure 1;
- figures 3-5 schematically show further details of the photovoltaic panel shown in figure 1;
- figures 6-9 schematically show mechanical connection means for installation of the photovoltaic panel shown in figure 1;

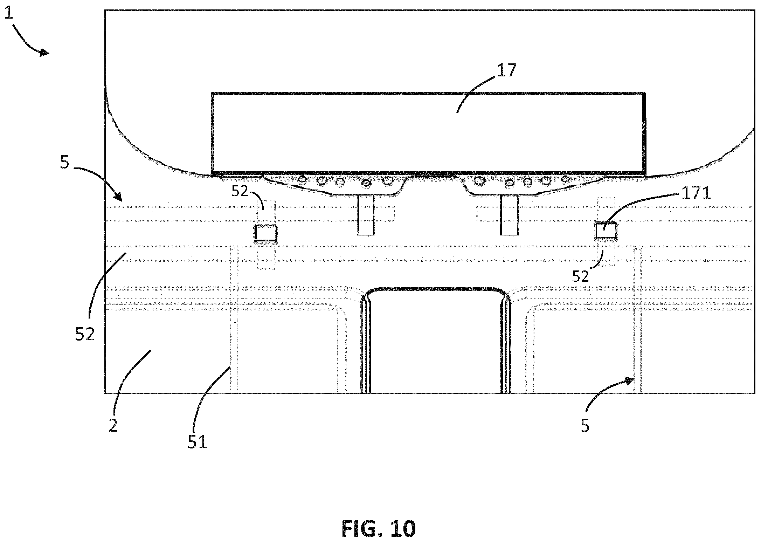

- figure 10 schematically shows further details of the photovoltaic panel shown in figure 1;
- figure 11 schematically shows an example of installation of the photovoltaic panel shown in figure 1;
- figure 12 schematically shows a further example of installation of the photovoltaic panel shown in figure 1.

With reference to the aforesaid figures, the present invention relates to a photovoltaic panel 1.

The photovoltaic panel 1 is intended to be placed on an installation structure 100. This installation structure can be of any type, for example civil or industrial roofing, a trellis structure, a tensile structure, and so on.

The photovoltaic panel 1 comprises a plurality of photovoltaic modules 2 adapted to provide electric power, when illuminated by a suitable source of light radiation (normally sunlight) on at least on active surface 22 (and possibly 21).

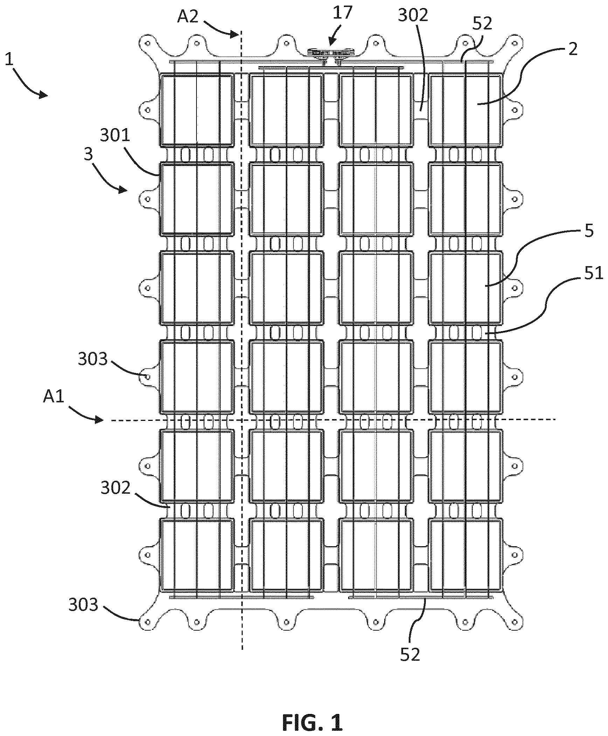

The photovoltaic modules 2 are spaced one from another according to a horizontal direction and according to vertical directions (with reference to a normal installation position of the panel on a flat surface as shown in figure 1).

In principle, the layout of the photovoltaic modules 2 may be any, according to needs.

Preferably, the photovoltaic modules 2 are arranged according to a matrix layout as shown in the aforesaid figures.

The photovoltaic modules 2 may each comprise one or more photovoltaic cells. Preferably each photovoltaic module 2 comprises a single photovoltaic cell.

Advantageously, the photovoltaic modules 2 comprise a first surface 21 and a second surface 22 opposite each other.

The photovoltaic modules 2 may be of a single-face type. In this case, the second surface 22 of the aforesaid modules constitutes the only active surface intended to receive the light radiation needed to effect photovoltaic conversion.

The photovoltaic modules 2 may also be of a dual-face type. In this case, both surfaces 21, 22 of the aforesaid modules constitute active surfaces intended to receive the light radiation needed to effect photovoltaic conversion.

In general, the photovoltaic modules 2 (typically made of a semi-conducting material) may be of a known type and will therefore not be further described herein for obvious motives of brevity.

The photovoltaic panel 1 comprises an electrical circuit adapted to make available to the outside the electrical power generated by the photovoltaic modules 2.

This electrical circuit advantageously comprises a plurality of conductive elements 5 adapted to electrically connect the photovoltaic modules 2 to one another.

The conductive elements 5 can be connected to the photovoltaic modules 2 using a known method.

Preferably, the electrical circuit of the photovoltaic panel 1 comprises a junction box 17 (J-Box) and appropriate electronic components 171 (e.g. diodes or other electronic discrete devices) electrically connected to the conductive elements 5 so as to ensure an adequate transmission of electrical power generated by the photovoltaic modules 2 and so as to protect the photovoltaic modules from possible electrical faults (e.g. short circuits).

The junction box 17 may comprise a single electronic modules or a plurality of electronic modules electrically connected one with another.

In general, the junction box 17 may be of a known type and will therefore not be further described herein for obvious motives of brevity.

The photovoltaic panel 1 comprises a support and protection structure 3 for the photovoltaic modules 2 and the conductive elements 5.

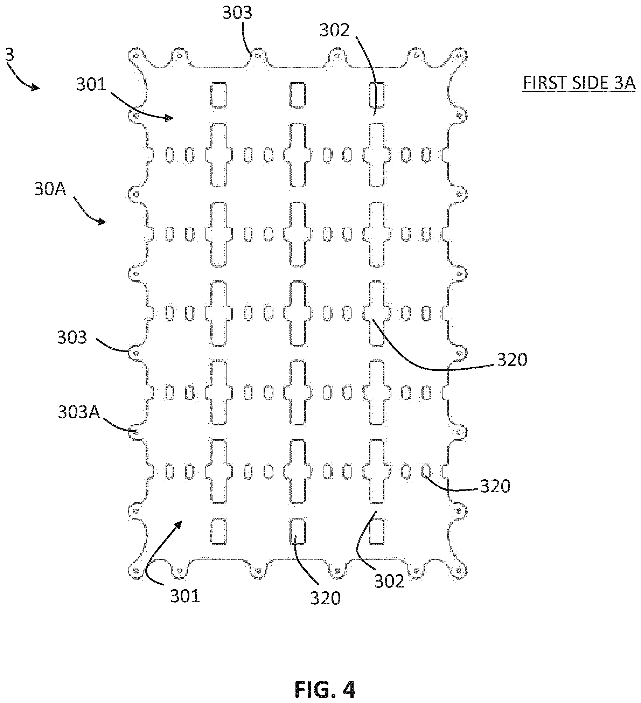

As a whole, the support and protection structure 3 has a substantially planar geometry and comprises a first side 3A and second side 3B opposite one another, at the first and second surfaces 21, 22 of the photovoltaic modules 2 (figures 4-5) respectively.

The support and protection structure 3 is intended to bind the photovoltaic modules 2 to one another, keeping them mutually separated and mechanically connected to form an assembly having a certain desired layout.

The support and protection structure 3 is also intended to protect and electrically insulate the photovoltaic modules 2 and the conductive elements 5 from the outside environment.

The support and protection structure 3 comprises a plurality of encapsulation portions 301 at each of which a corresponding photovoltaic module 2 is placed.

Advantageously, each encapsulation portion 301 defines a volume inside which a corresponding photovoltaic module 2 is placed.

The support and protection structure 3 comprises one or more connection portions 302 adapted to mechanically connect the encapsulation portions 301 to one another.

Advantageously, the connection portions 302 are arranged to connect adjacent encapsulation portions 301. They are therefore substantially positioned at the central zones of the photovoltaic panel 1 at the spaces between pairs of adjacent photovoltaic modules.

According to the invention, the connection portions 302 are flexible so that the support and protection structure 3 is foldable at the aforesaid connection portions according to at least two mutually perpendicular axes, more particularly according to a horizontal axis A1 and a vertical axis A2 (with reference to a normal installation position of the panel on a flat surface as shown in figure 1).

In this way, the whole structure of the photovoltaic panel 1 is not rigid as it is in known solutions, but rather is able to bend at the connection portions 302 of the support and protection structure 3.

In the embodiment of the invention shown in figure 1, the photovoltaic modules 2 are arranged in a matrix layout, separated from one another. The connection portions 302 of the support and protection structure 3 are present at the separation spaces between the modules. The support and protection structure 3 (and thus the photovoltaic panel 1) are foldable along one or more horizontal axes A1 and vertical axes A2 (with reference to a normal installation position of the panel on a flat surface as shown in figure 1), respectively parallel to the rows and columns of photovoltaic modules.

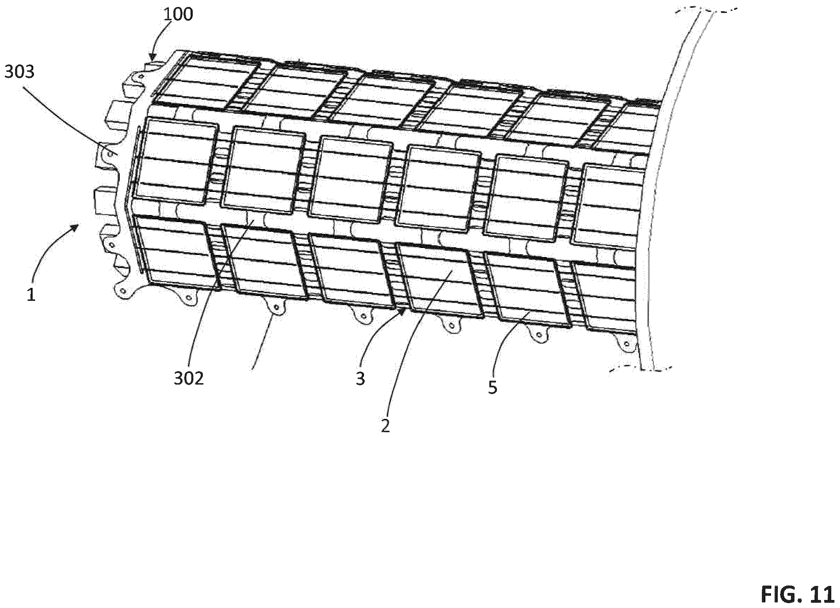

Thanks to its foldable structure, the photovoltaic panel 1 can also be installed on installation structures 100 with non-planar support surfaces. For example, it can be installed wrapped around a trellis (figure 11).

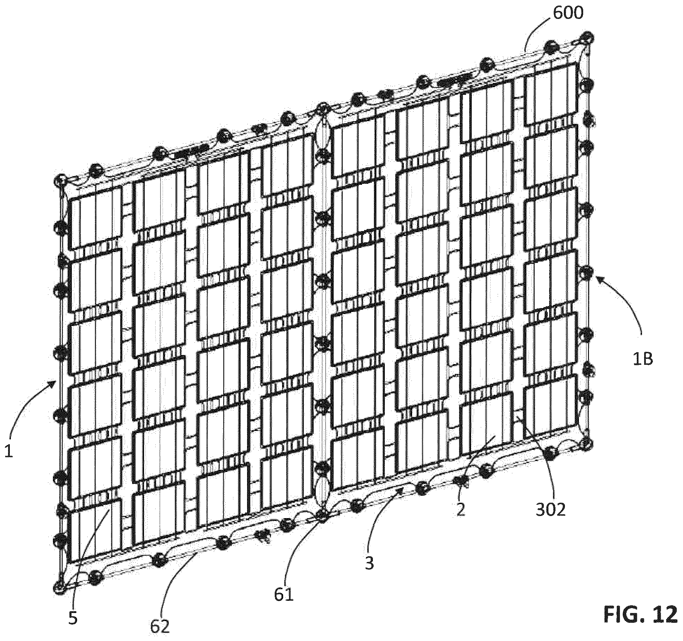

Obviously, the photovoltaic panel 1 is particularly easy to install on civil or industrial roofing (figure 12).

Preferably, the support and protection structure 3 is made, at least partially, of a polymeric material. This solution makes it possible to drastically reduce the weight and thickness of the photovoltaic panel 1, thereby making it particularly suitable for installation on tensile structures or vertical walls.

Preferably, the support and protection structure 3 is made, at least partially, of a (preferably polymeric) material transparent to the light radiation intended to illuminate the photovoltaic modules 2. This helps to simplify the manufacture of the support and protection structure and makes it possible to drastically reduce the aesthetic impact of the photovoltaic panel 1.

The conductive elements 5 of the photovoltaic panel 1 comprise first flexible portions 51 arranged at respective connection portions 302 of the support and protection structure 3 to favour the folding of said structure at said connection portions.

Preferably, the first flexible portions 51 are made up of conductive ribbons ("Tabbing Ribbons") arranged so as to electrically connect the photovoltaic modules 2 to one another or with the junction box 17.

The support and protection structure 3 comprises one or more anchoring portions 303 at which said support is mechanically connectable with an installation structure 100 or with a further photovoltaic panel.

Preferably, the anchoring portions 303 are flexible so that the support and protection structure 3 is slightly deformable (e.g. by traction) at the aforesaid anchoring portions.

Preferably, the anchoring portions 3 are connected to the encapsulation portions 301 and to the connection portions 302 of the support and protection structure 3 and are advantageously placed at the outer edges of the photovoltaic panel 1.

Preferably, at the anchoring portions 303, there are present first shaped holes 303A passing through the thickness of the support and protection structure 3.

The first shaped holes 303A are intended to be coupled with suitable mechanical connection means 6 for connecting the photovoltaic panel 1 with an installation structure 100 or a further photovoltaic panel.

The arrangement of the anchoring portions 303 considerably facilitates installation of the photovoltaic panel 1, thereby making it particularly suitable for installation on tensile structures or vertical walls.

Preferably, the conductive elements 5 comprise second flexible conductive portions 52 arranged at respective anchoring portions 303 of the support and protection structure 3.

Preferably, the second flexible portions 52 are made up of conductive ribbons ("Bus Ribbons") arranged so as to connect the first flexible conductive portions 51 to one another or with the electric junction box 17.

Preferably, the support and protection structure 3 is covered with holes at the connection portions 302. In practice, the connection portions 302 are at least partially separated from one another by second shaped holes 320 passing through the thickness of the support and protection structure 3.

This greatly increases the flexibility of the connection portions 302 favouring the possible folding of the support and protection structure 3.

Furthermore, this solution makes it possible to drastically limit the mechanical loads due to wind and other atmospheric agents (e.g. rain water), while at the same time ensuring adequate air circulation over both surfaces 21, 22 of the photovoltaic modules 2, whatever the type of installation chosen for the photovoltaic panel 1. The connection portions 302 arranged with holes 320 thus allows achieving a more efficient cooling (through ventilation fluxes passing through said holes) of the photovoltaic modules 2 when the environmental temperature is high.

Preferably, the support and protection structure 3 comprises a plurality of protection elements 35 made of material transparent to the light radiation intended to illuminate the photovoltaic modules 2.

Each protection element 35 is operatively associated with a respective photovoltaic module 2 at a surface thereof, for example the second surface 22, as shown in the aforesaid figures.

Preferably, the protection elements 35 are slab-shaped, having a shape and size (height and width) equal to or slightly larger than the photovoltaic modules 2.

Preferably, the protection elements 35 have a thickness of less than 4 mm, e.g. somewhere between 2 and 3 mm

Preferably, the protection elements 35 are made of glass, advantageously of ultra-clear glass, for example tempered glass with a transmittance of over 90% and an iron content below 150 ppm.

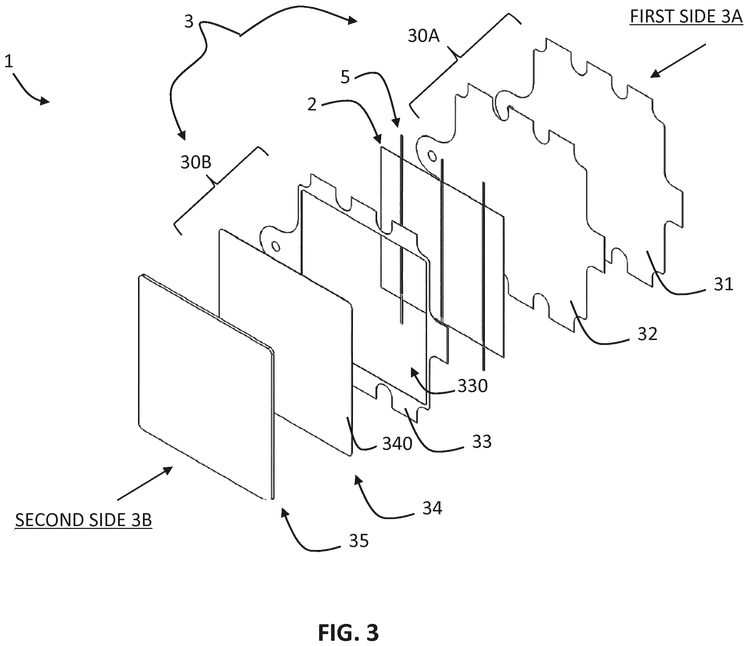

With reference to figures 3-5, there is now described a preferred embodiment of the invention, according to which the support and protection structure 3 is made as a multi-layer laminated structure (preferably of a polymeric material) that incorporates the photovoltaic modules 2 in its thickness and preferably has the protection elements 35 at a surface 22 of said modules.

According to this embodiment, the support and protection structure 3 comprises a first multi-layer half-shell 30A (preferably of a polymeric material), operatively associated with the first surface 21 of the photovoltaic modules 2, and a second multi-layer half-shell 30B (preferably of a polymeric material), operatively associated with the second surface 22 of the photovoltaic modules 2.

The half-shells 30A, 30B are joined to the photovoltaic modules 2 at the surfaces 21, 22 of said modules respectively.

Being kept at a distance from the photovoltaic modules 2 interposed between them, the half-shells 30A, 30B thus define the encapsulation portions 301 of the support and protection structure 3 at the sides 3A, 3B thereof.

In this way, each encapsulation portion 301 is shaped so as to have a complementary shape (i.e. without the presence of free spaces) with respect to that of the respective photovoltaic module 2.

The half-shells 30A, 30B are mutually joined at the connection portions 302 and, preferably, at the anchoring portions 303 of the support and protection structure 3.

The half-shells 30A, 30B are advantageously arranged so as to encapsulate inside them the conductors 5, in particular the flexible conductive portions 51, 52, where these conductors are present at the connection portions 302 and, preferably, at the anchoring portions 303.

In figures 3 and 4, is it possible to observe the half-shell 30A of the support and protection structure 3. This half-shell is made up of a pair of overlapping layers (preferably of a polymeric material).

Preferably, the support and protection structure 3 comprises a first protection layer 31 (preferably of a polymeric material).

The first protection layer 31 is found in a distal position with respect to the first surface 21 of the photovoltaic modules 2 so as to constitute the outermost layer of the support and protection structure 3 at the first side 3A thereof (figure 4).

Preferably, the first protection layer 31 is made of a transparent (preferably polymeric), electrically insulating and fire-resistant material, such as TEDLAR⁽™⁾.

Preferably, the first protection layer 31 is made up of a corresponding shaped sheet of polymeric material.

Preferably, the support and protection structure 3 comprises a first encapsulation layer 32 (preferably of a polymeric material).

The first encapsulation layer 32 overlaps the first protection layer 31 so as to be interposed between said layer and the first surface 21 of the photovoltaic modules 2.

The first encapsulation layer 32 is bonded to the first surface 21 of the photovoltaic modules 2 so as to cover them at this surface.

Advantageously, the first encapsulation layer 32 is arranged so as to also cover the conductors 5 at the first side 3A of the support and protection structure 3, where these conductors are present at the connection portions 302 and, preferably, at the anchoring portions 303.

Preferably, the first encapsulation layer 31 is made of transparent (preferably polymeric) material, such as EVA (Ethylene Vinyl-Acetate) or an ionomer resin.

Preferably, the first encapsulation layer 32 is made up of a corresponding shaped sheet of polymeric material. Advantageously, this sheet of polymeric material has, along its plane of extension, the same geometric form as the sheet of polymeric material making up the first protection layer 31 so as to be substantially able to completely overlap said layer.

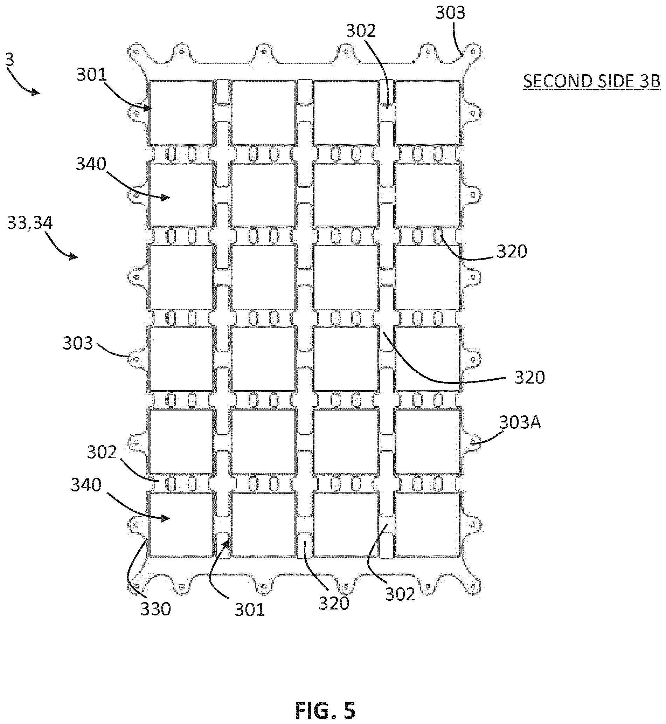

In figures 3 and 5, it is possible to observe the half-shell 30B of the support and protection structure 3. This half-shell is made up of a pair of layers (preferably of a polymeric material) arranged so as to be geometrically complementary along a common plane of extension.

Preferably, the support and protection structure 3 comprises a second protection layer 33 (preferably of a polymeric material).

The second protection layer 33 is bonded to the first encapsulation layer 32 at the connection portions 302 and, preferably, at the anchoring portions of the support and protection structure 3.

The second protection layer 31 constitutes the outermost layer of the connection portions 302 and, preferably, of the anchoring portions 303 of the support and protection structure 3 at the second side 3B thereof (figure 5).

Advantageously, the second encapsulation layer 33 is arranged so as to cover the conductors 5 at the second side 3B of the support and protection structure 3, where these conductors are present at the connection portions 302 and, preferably, at the anchoring portions 303.

The second protection layer 33 comprises a plurality of mutually spaced apertures 330 (figure 3). Each aperture 330 of the second protection layer 33 is positioned at a respective photovoltaic module 2, in particular at the surface 22 thereof.

Advantageously, each aperture 330 of the second protection layer 33 has a form and dimensions coinciding with the form and dimensions of the surface 22 of the photovoltaic module 2 with which this aperture is operatively associated.

The second protection layer 33 is therefore arranged so as not to cover the photovoltaic modules 2 at the second surface 22 thereof.

Preferably, the second protection layer 33 is made of a transparent (preferably polymeric), electrically insulating and fire-resistant material, such as TEDLAR(™).

Preferably, the second protection layer 33 is made up of a corresponding shaped sheet of polymeric material. Advantageously, at the connection portions 302 and, preferably, at the anchoring portions 303 of the support and protection structure 3, this sheet of polymeric material has, along its plane of extension, the same geometric form as the sheets of polymeric material making up the first protection layer 31 and the first encapsulation layer 32 of the support and protection structure 3 so as to be substantially able to completely overlap said layers. Furthermore, this sheet of polymeric material comprises a plurality of shaped, through-passing, mutually spaced apertures, each of which is intended to constitute a corresponding aperture 330 of the second protection layer 33.

Preferably, the support and protection structure 3 comprises a second encapsulation layer 34 (preferably of a polymeric material).

The second encapsulation layer 34 comprises a plurality of mutually spaced portions 340.

Each portion 340 of the second encapsulation layer 34 is arranged at a respective aperture 330 of the second protection layer 33.

Each portion 340 of the second encapsulation layer 34 is bonded to the second surface 22 of a corresponding photovoltaic module 2 so as to cover it at this surface.

Advantageously, each portion 340 of the second encapsulation layer 34 has a form and dimensions coinciding with the form and dimensions of the surface 22 of the photovoltaic module 2 and of the respective aperture 330 of the second protection layer 33 with which this portion is operatively associated.

In this way, each portion 340 of the second encapsulation layer 34 completely covers the respective photovoltaic module 2 at the second surface 22 thereof.

Preferably, the second encapsulation layer 34 is made of transparent (preferably polymeric) material, such as EVA or an ionomer resin.

Preferably, the second encapsulation layer 34 is made up of a plurality of corresponding shaped sheets of polymeric material, each of which is intended to form a portion 340 of the aforesaid layer. Advantageously, each sheet of polymeric material has, along its plane of extension, the same geometric form as the second surface 22 of a corresponding photovoltaic module 2 and of a respective through-passing aperture of the sheet of polymeric material that constitutes the second protection layer 33.

According to the embodiment shown in figures 3-5, the protection elements 35 of the support and protection structure 3 are joined to the second shell 30B of said structure at the respective photovoltaic modules 2.

Preferably, each protection element 35 is bonded to a corresponding portion 340 of the second encapsulation layer 34 so as to cover said layer at the second surface 22 of a respective photovoltaic module 2.

Advantageously, each protection element 35 has, along its plane of extension, the same geometric form as the corresponding portion 340 of the second encapsulation layer 34 so as to completely cover said layer.

The protection elements 35 thus constitute the outermost layer of the encapsulation portions 330 of the support and protection structure 3 at the second side 3B thereof.

In the embodiment shown in figures 3-5, the photovoltaic panel 1 can be created using a hot rolling process (preferably under vacuum).

Preferably, a fabrication method for the photovoltaic panel 1 comprises the step of providing a semi-finished structure comprising:
- a first sheet of polymeric material adapted to form the first protection layer 31 of the support and protection structure 3;
- a second sheet of polymeric material adapted to form the first encapsulation layer 32 of the support and protection structure 3. The second sheet of polymeric material overlaps the first sheet of polymeric material;
- the photovoltaic modules 2 overlapping the second sheet of polymeric material, at the encapsulation portions 301 of the support and protection structure 3. The photovoltaic modules overlap the second sheet of polymeric material at the first surface 21;
- the conductive elements 5 electrically connected to the photovoltaic modules 2 and overlapping the second sheet of polymeric material;
- a third sheet of polymeric material adapted to form the second protection layer 33 of the support and protection structure 3. The third sheet of polymeric material overlaps the second sheet of polymeric material and the conductive elements 5 at the connection portions 302 and, preferably, at the anchoring portions 303 of the support and protection structure 3. The third sheet of polymeric material has through-passing apertures at the photovoltaic modules 2;
- a plurality of fourth sheets of polymeric material adapted to form the portions 340 of the second encapsulation layer 34. Each fourth sheet of polymeric material is positioned at a respective through-passing aperture of the third sheet of polymeric material and overlaps a respective photovoltaic module 2 at the second surface 22 thereof.

Preferably, the fabrication method of the photovoltaic panel 1 comprises the step of subjecting the aforesaid semi-finished structure to a hot rolling process (preferably under vacuum).

Preferably, the semi-finished structure described above also comprises the protection elements 35 of the support and protection structure 3. Each protection element 35 overlaps a respective fourth sheet of polymeric material at a respective photovoltaic module 2.

Preferably, the aforesaid semi-finished structure also comprises the junction box 17 electrically connected to the conductive elements 5. The junction box 17 is arranged so as to be covered by the first encapsulation layer 32 and by the second protection layer 33.

As an alternative, the junction box 17 may be not covered by the layers 32, 33 and be arranged externally to the support and protection structure 3 once this latter is finished.

According to a preferred embodiment, the photovoltaic panel 1 comprises mechanical connection means 6 adapted to mechanically connect the support and protection structure 3 with an installation structure 100 or a further photovoltaic panel.

Preferably, the mechanical connection means 6 preferably comprise first mechanical connection elements 61 operatively joinable with the support and protection structure 3 at the anchoring portions 303 thereof.

Preferably, the first mechanical connection elements 61 are made of Nylon⁽™⁾ or another material resistant to atmospheric agents.

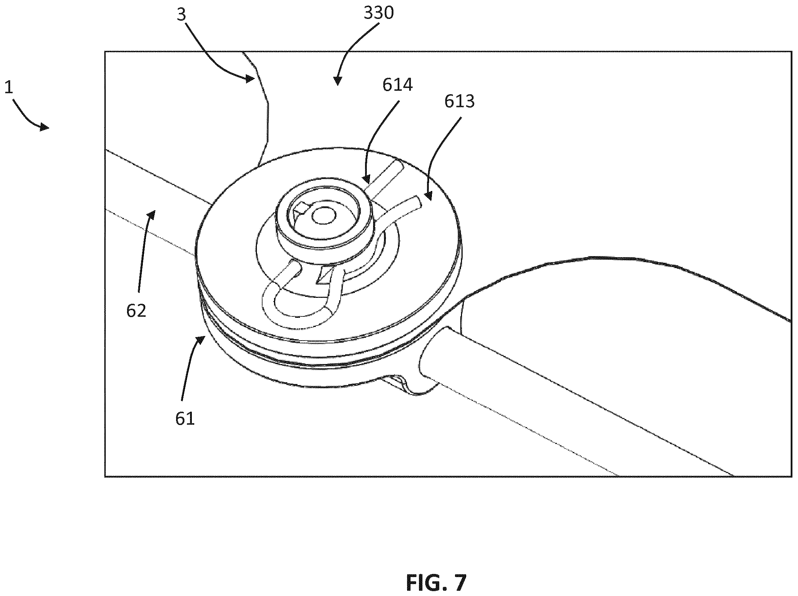

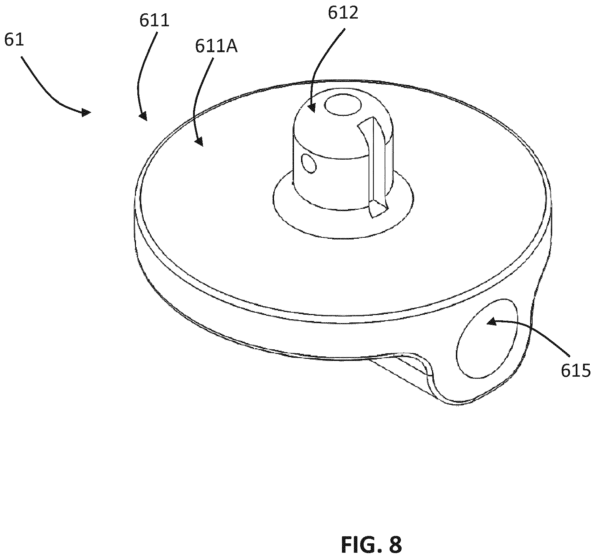

Preferably, a first mechanical connection element 61 comprises a shaped base 611 provided with a coupling surface 611A from which a pin 612 protrudes, intended to be inserted in a corresponding shaped hole 303A of an anchoring portion 303 of the support and protection structure 3 (figures 7-9).

A washer 613 and a peg 614 can be coupled with the pin 612 (after it is inserted in the corresponding shaped hole 303A) of the shaped base 611 to fix the first mechanical connection element 61 to an anchoring portion 303 of the support and protection structure 3.

Obviously, as shown in figure 11, should it be necessary to join several photovoltaic panels 1, 1B to one another, the pin 612 is intended to be inserted in a pair of aligned holes 303A belonging to corresponding anchoring portions 303 (coupled and overlapping) of the support and protection structures 3 of the photovoltaic panels 1, 1B to be joined (figure 12).

In embodiments of the photovoltaic panel 1 that are particularly advantageous for installation on civil or industrial roofing or on planar installation structures (for example tiled roofs or scaled or on vertical walls), the mechanical connection means 6 comprise one or more second mechanical connection elements 62 adapted to operatively connect the first mechanical connection elements 61 with one another and with one or more third mechanical connection elements 63 adapted to operatively connect the second mechanical connection elements with the installation structure 100 (figure 12).

Preferably, the second and third mechanical connection elements 62, 63 are made of Nylon(™) or another material resistant to atmospheric agents.

Preferably, a second shaped connection element 62 comprises a shaped rod slidingly joinable with one or more first mechanical connection elements 61.

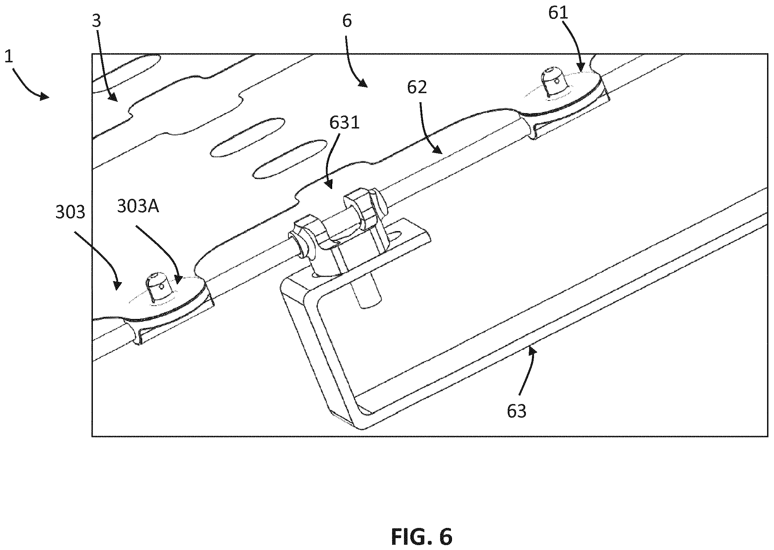

To that end, the shaped base 611 of each first mechanical connection element 61 may advantageously comprise one or more through-passing holes 615 intended to receive corresponding shaped rods 62 (figures 6-7).

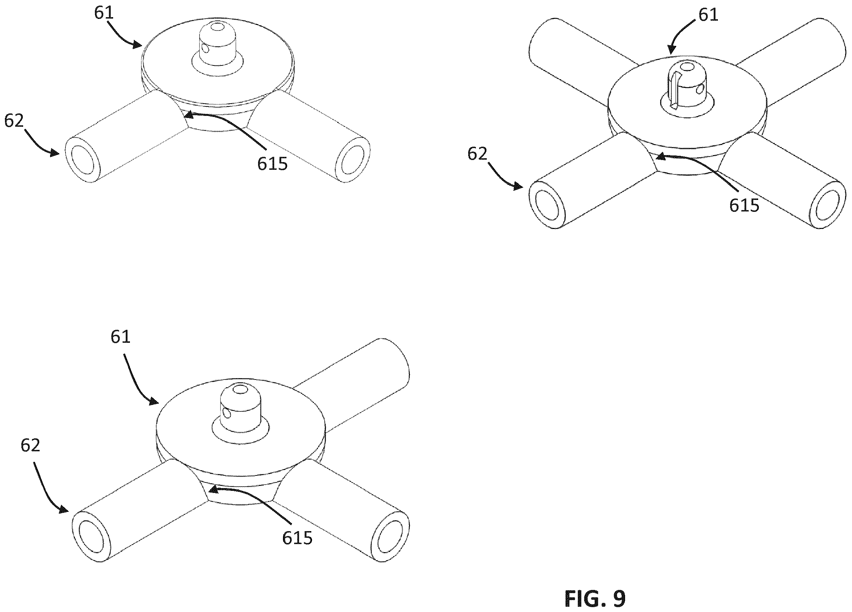

Examples of different mechanical connection elements 61 arranged so as to be joinable with two, three or four shaped rods 62 can be seen in figure 9.

Preferably (figure 6), a third shaped connection element 63 comprises a shaped bracket operatively joined to a corresponding shaped rod 62 by means of an adjustable connection element 631 (e.g. a bolt or a connection slide).

The second and third mechanical connection elements 62-63, suitably connected to one another, are able to provide a very light stiffening structure 600 that can be easily adapted to the dimensions of the support and protection structure 3 (figure 12).

This stiffening structure is particularly suitable for being anchored to a roof 100 and enables pre-tensioning of the support and protection structure 3 of the photovoltaic panel 1 (or photovoltaic panels 1, 1B bonded to one another) thereby assuring the correct positioning of the photovoltaic modules 2.

Furthermore, this stiffening structure is particularly useful for maintaining an adequate separation space between the photovoltaic modules and the roofing 100, thereby ensuring adequate cooling of the photovoltaic cells and, at the same time, making it possible to limit buffeting of the photovoltaic panel in the event of wind.

It has been seen in practice how the photovoltaic panel 1, according to the present invention, allows the proposed aim and the objects to be fully achieved.

The photovoltaic panel 1 is characterized by extreme flexibility of use.

As can be seen in figure 11, thanks to an overall semi-flexible structure, the photovoltaic panel 1 can be easily placed on installation structures having curved, vaulted, cylindrical, or multi-sided geometry, and so on. For example, it can be rolled, at least partially, for use on trellis structures for agricultural use or open-air structures (arenas, stadia, etc.).

On the other hand, the photovoltaic panel 1 is particularly suitable for installation on a traditional type of civil or industrial roofing, for example on a tiled roof 100, as can be seen in figure 12.

Thanks to the preferential use of polymeric materials, the photovoltaic panel according to the present invention, has a greatly reduced thickness and weight. For example, it may have a thickness of between 2.5 and 3.5 mm (excluding the electrical junction unit) and a total weight of less than 5 Kg/m².

The photovoltaic panel 1 can therefore be used on any type of civil or industrial roofing, and is particularly suitable for installation on vertical walls or tensile structures.

The photovoltaic panel, according to the present invention, is easy and cheap to manufacture industrially. As shown, it can be manufactured using a hot rolling process.

The photovoltaic panel 1 could in practice be manufactured in further embodiments, all of which fall within the scope of the present invention.

The support and protection structure 3 may have a different form from that shown in the aforesaid figures.

The encapsulation portions 301, connection portions 302 and anchoring portions 303 of the support and protection structure 3 may have different forms from those shown in the aforesaid figures

The support and protection structure 3 may comprise layers of material not transparent to light radiation. For example, in the case where the photovoltaic modules 2 are of a single-face type, the layers 31, 32 of the support and protection structure 3 may be made of an opaque or coloured material (e.g. a polymeric material).

The conductive elements 5 may have a different arrangement from that shown in the aforesaid figures.

The photovoltaic modules 2 may have a form or arrangement different from those shown in the aforesaid figures.

## Claims

1. Photovoltaic panel (1) comprising:
- a plurality of photovoltaic modules (2) adapted to provide electric power when illuminated by a light radiation on at least a surface (21, 22), said photovoltaic modules being mutually spaced one from another according to horizontal and vertical directions;
- one or more conductive elements (5) for the electrical connection of said photovoltaic modules;
- a support and protection structure (3) for said photovoltaic modules and said conductive elements, said support and protection structure comprising one or more anchoring portions (303), at which said support and protection structure is connectable with an installation structure (100) or with a further photovoltaic panel (1B), and a plurality of encapsulation portions (301), at which said photovoltaic modules are arranged, and one or more connection portions (302) adapted to connect said encapsulation portions one with another, said connection portions being flexible so that said support and protection structure is foldable at said connection portions according to at least two mutually perpendicular axes (A1, A2);
wherein said conductive elements (5) comprise first flexible portions (51) arranged at respective connection portions (302) of said support and protection structure (3) to favor the folding of said support and protection structure at said respective connection portions.

2. Photovoltaic panel, according to claim 1, **characterized in that** said support and protection structure (3) is made, at least partially, of a polymeric material.

3. Photovoltaic panel, according to one or more of the previous claims, **characterized in that** said support and protection structure (3) is made, at least partially, of material transparent to said light radiation.

4. Photovoltaic panel, according to one or more of the previous claims, **characterized in that** said support and protection structure (3) is covered with holes at said connection portions (302).

5. Photovoltaic panel, according to one or more of the previous claims, **characterized in that** said support and protection structure (3) comprises a plurality of protection elements (35) made of material transparent to said light radiation, each protection element being operatively associated with a respective photovoltaic module (2) at a surface (22) of said photovoltaic module.

6. Photovoltaic panel, according to one or more of the previous claims, **characterized in that** said support and protection structure (3) comprises:
- a first protection layer (31);
- a first encapsulation layer (32) bonded to said first protection layer, said first encapsulation layer covering said photovoltaic modules (2) at a first surface (21) of said photovoltaic modules;
- a second protection layer (33) bonded to said first encapsulation layer at the connection portions (302) of said support and protection structure, said second protection layer comprising a plurality of mutually spaced apertures (330), each aperture being positioned at a second surface (22) of a respective photovoltaic module, which is opposed to said first surface (21);
- a second encapsulation layer (34) comprising a plurality of mutually spaced portions (340), each portion being arranged at a respective aperture (330) of said second protection layer to cover a respective photovoltaic module (2) at said second surface (22).

7. Photovoltaic panel, according to claim 6, **characterized in that** each protection element (35) is arranged to cover a corresponding portion (340) of said second encapsulation layer (34) at the second surface (22) of a respective photovoltaic module (2).

8. Photovoltaic panel, according to one or more of the previous claims, **characterized in that** it comprises mechanical connection means (6) adapted to connect said support and protection structure (3) with an installation structure (100) or a further photovoltaic panel (1B).

9. A photovoltaic plant **characterized in that** it comprises a photovoltaic panel (1), according to one or more of the previous claims.

10. A method to fabricate a photovoltaic panel (1), according to one or more of the claims from 1 to 8, **characterized in that** of comprising the step of providing a semi-finished structure comprising:
- a first sheet of polymeric material adapted to form a first protection layer (31) of said support and protection structure (3);
- a second sheet of polymeric material adapted to form a first encapsulation layer (32) of said support and protection structure, said second sheet of polymeric material being overlapped to said first sheet of polymeric material;
- said photovoltaic modules (2) overlapped to said second sheet of polymeric material at the encapsulation portions (301) of said support and protection structure at a first surface (21) of said photovoltaic modules;
- said conductive elements (5) electrically connected to said photovoltaic modules overlapped to said second sheet of polymeric material;
- a third sheet of polymeric material adapted to form a second protection layer (33) of said support and protection structure (3), said third sheet of polymeric material being overlapped to said second sheet of polymeric material and to said conductive elements (5) at the connection portions (302) of said support and protection structure, said third sheet of polymeric material having apertures (330) at said photovoltaic modules;
- fourth sheets of polymeric material adapted to form corresponding portions (340) of a second encapsulation layer (34), said fourth sheets of polymeric material being positioned at respective apertures of said third sheet of polymeric material and being overlapped to said photovoltaic modules (2) at a second surface (22) of said photovoltaic modules, which is opposite to said first surface (21);
and the step of subjecting said semi-finished structure to a hot rolling mill process.

11. Method, according to claim 10, **characterized in that** said semi-finished structure comprises protection elements (35) in material transparent to said light radiation, which are overlapped to respective fourth sheets of polymeric material at respective photovoltaic modules (2).

## Patentansprüche

1. Photovoltaikpanel (1), aufweisend:
- eine Mehrzahl an Photovoltaikmodulen (2), die darauf ausgelegt sind, elektrische Leistung bereitzustellen, wenn sie durch eine Lichteinstrahlung auf zumindest einer Oberfläche (21, 22) beleuchtet werden, wobei die Photovoltaikmodule gemäß horizontalen und vertikalen Richtungen voneinander beabstandet sind;
- ein oder mehrere leitfähige Elemente (5) für die elektrische Verbindung der Photovoltaikmodule;
- eine Trag- und Schutzstruktur (3) für die Photovoltaikmodule und die leitfähigen Elemente, wobei die Trag- und Schutzstruktur einen oder mehrere Verankerungsabschnitte (303), an denen die Trag- und Schutzstruktur mit einer Installationsstruktur (100) oder mit einem weiteren Photovoltaikpanel (1B) verbunden werden kann, und eine Mehrzahl an Verkapselungsabschnitten (301), an denen die Photovoltaikmodule angeordnet sind, und einen oder mehrere Verbindungsabschnitte (302), die darauf ausgelegt sind, die Verkapselungsabschnitte miteinander zu verbinden, aufweist, wobei die Verbindungsabschnitte flexibel sind, so dass die Trag- und Schutzstruktur an den Verbindungsabschnitten gemäß zumindest zwei zueinander rechtwinkligen Achsen (A1, A2) faltbar ist;
wobei die leitfähigen Elemente (5) erste flexible Abschnitte (51) aufweisen, die an entsprechenden Verbindungsabschnitten (302) der Trag- und Schutzstruktur (3) angeordnet sind, um das Falten der Trag- und Schutzstruktur an den entsprechenden Verbindungsabschnitten zu erleichtern.

2. Photovoltaikpanel nach Anspruch 1, **dadurch gekennzeichnet, dass** die Trag- und Schutzstruktur (3) zumindest teilweise aus einem Polymermaterial besteht.

3. Photovoltaikpanel nach einem oder mehreren der vorgenannten Ansprüche, **dadurch gekennzeichnet, dass** die Trag- und Schutzstruktur (3) zumindest teilweise aus einem Material besteht, das gegenüber der Lichteinstrahlung transparent ist.

4. Photovoltaikpanel nach einem oder mehreren der vorgenannten Ansprüche, **dadurch gekennzeichnet, dass** die Trag- und Schutzstruktur (3) an den Verbindungsabschnitten (302) mit Löchern versehen ist.

5. Photovoltaikpanel nach einem oder mehreren der vorgenannten Ansprüche, **dadurch gekennzeichnet, dass** die Trag- und Schutzstruktur (3) eine Mehrzahl an Schutzelementen (35) aufweist, die aus einem Material bestehen, das gegenüber der Lichteinstrahlung transparent ist, wobei jedes Schutzelement operativ einem entsprechenden Photovoltaikmodul (2) an einer Oberfläche (22) des Photovoltaikmoduls zugeordnet ist.

6. Photovoltaikpanel nach einem oder mehreren der vorgenannten Ansprüche, **dadurch gekennzeichnet, dass** die Trag- und Schutzstruktur (3) aufweist:
- eine erste Schutzschicht (31);
- eine erste Verkapselungsschicht (32), die mit der ersten Schutzschicht verklebt ist, wobei die erste Verkapselungsschicht die Photovoltaikmodule (2) an einer ersten Oberfläche (21) der Photovoltaikmodule abdeckt;
- eine zweite Schutzschicht (33), die mit der ersten Verkapselungsschicht an den Verbindungsabschnitten (302) der Trag- und Schutzstruktur verklebt ist, wobei die zweite Schutzschicht eine Mehrzahl an zueinander beabstandeten Öffnungen (330) aufweist, wobei jede Öffnung an einer zweiten Oberfläche (22) des entsprechenden Photovoltaikmoduls positioniert ist, die der ersten Oberfläche (21) gegenüberliegt;
- eine zweite Verkapselungsschicht (34), die eine Mehrzahl an voneinander beabstandeten Abschnitten (340) aufweist, wobei jeder Abschnitt an einer entsprechenden Öffnung (330) der zweiten Schutzschicht angeordnet ist, um ein entsprechendes Photovoltaikmodul (2) an der zweiten Oberfläche (22) abzudecken.

7. Photovoltaikpanel nach Anspruch 6, **dadurch gekennzeichnet, dass** jedes Schutzelement (35) so angeordnet ist, dass es einen entsprechenden Abschnitt (340) der zweiten Verkapselungsschicht (34) an der zweiten Oberfläche (22) des entsprechenden Photovoltaikmoduls (2) abdeckt.

8. Photovoltaikpanel nach einem oder mehreren der vorgenannten Ansprüche, **dadurch gekennzeichnet, dass** es eine mechanische Verbindungseinrichtung (6) aufweist, die darauf ausgelegt ist, die Trag- und Schutzstruktur (3) mit einer Installationsstruktur (100) oder einem weiteren Photovoltaikpanel (1B) zu verbinden.

9. Photovoltaik-Kraftwerk, **dadurch gekennzeichnet, dass** es ein Photovoltaikpanel (1) nach einem oder mehreren der vorgenannten Ansprüche aufweist.

10. Verfahren zum Herstellen eines Photovoltaikpanels (1) nach einem der Ansprüche 1 bis 8, **dadurch gekennzeichnet, dass** es den Schritt des Bereitstellens einer halbfertigen Struktur aufweist, aufweisend:
- ein erstes Blech aus Polymermaterial, das darauf ausgelegt ist, eine erste Schutzschicht (31) der Trag- und Schutzstruktur (3) zu bilden;
- ein zweites Blech aus Polymermaterial, das darauf ausgelegt ist, eine erste Verkapselungsschicht (32) der Trag- und Schutzstruktur zu bilden, wobei sich das zweite Blech aus Polymermaterial mit dem ersten Blech aus Polymermaterial überlappt;
- wobei sich die Photovoltaikmodule (2) mit dem zweiten Blech aus Polymermaterial an den Verkapselungsabschnitten (301) der Trag- und Schutzstruktur an einer ersten Oberfläche (21) der Photovoltaikmodule überlappen;
- wobei sich die leitfähigen Elemente (5), die mit den Photovoltaikmodulen elektrisch verbunden sind, mit dem zweiten Blech aus Polymermaterial überlappen;
- ein drittes Blech aus Polymermaterial, das darauf ausgelegt ist, eine zweite Schutzschicht (33) der Trag- und Schutzstruktur (3) zu bilden, wobei sich das dritte Blech aus Polymermaterial mit dem zweiten Blech aus Polymermaterial und den leitfähigen Elementen (5) an den Verbindungsabschnitten (302) der Trag- und Schutzstruktur überlappt, wobei das dritte Blech aus Polymermaterial Öffnungen (330) an den Photovoltaikmodulen aufweist;
- vierte Bleche aus Polymermaterial, die darauf ausgelegt sind, entsprechende Abschnitte (340) einer zweiten Verkapselungsschicht (34) zu bilden, wobei die vierten Bleche aus Polymermaterial an entsprechenden Öffnungen des dritten Blechs aus Polymermaterial positioniert werden und sich mit den Photovoltaikmodulen (2) an einer zweiten Oberfläche (22) der Photovoltaikmodule, die der ersten Oberfläche (21) gegenüberliegt, überlappen;
sowie den Schritt, bei dem die halbfertige Struktur einem Warmwalzvorgang unterzogen wird, aufweist.

11. Verfahren nach Anspruch 10, **dadurch gekennzeichnet, dass** die halbfertige Struktur Schutzelemente (35) in dem Material aufweist, das gegenüber der Lichteinstrahlung transparent ist, die sich mit entsprechenden vierten Blechen aus Polymermaterial an entsprechenden Photovoltaikmodulen (2) überlappen.

## Revendications

1. Panneau photovoltaïque (1) comprenant :
- une pluralité de modules photovoltaïques (2) adaptés pour fournir de l'énergie électrique lorsqu'ils sont éclairés par un rayonnement lumineux sur au moins une surface (21, 22), lesdits modules photovoltaïques étant mutuellement espacés les uns des autres selon des directions horizontale et verticale ;
- un ou plusieurs éléments conducteurs (5) pour la connexion électrique desdits modules photovoltaïques ;
- une structure de support et de protection (3) pour lesdits modules photovoltaïques et lesdits éléments conducteurs, ladite structure de support et de protection comprenant une ou plusieurs parties d'ancrage (303), au niveau desquelles ladite structure de support et de protection peut être connectée à une structure d'installation (100) ou avec un panneau photovoltaïque supplémentaire (1B), et une pluralité de parties d'encapsulation (301), au niveau desquelles lesdits modules photovoltaïques sont agencés, et une ou plusieurs parties de connexion (302) adaptées pour connecter lesdites parties d'encapsulation les unes aux autres, lesdites parties de connexion étant flexibles de sorte que ladite structure de support et de protection est pliable au niveau desdites parties de connexion selon au moins deux axes mutuellement perpendiculaires (A1, A2) ;
dans lequel lesdits éléments conducteurs (5) comprennent des premières parties flexibles (51) agencées au niveau des parties de connexion respectives (302) de ladite structure de support et de protection (3) pour favoriser le pliage de ladite structure de support et de protection au niveau desdites parties de connexion respectives.

2. Panneau photovoltaïque selon la revendication 1, **caractérisé en ce que** ladite structure de support et de protection (3) est réalisée, au moins partiellement, en un matériau polymère.

3. Panneau photovoltaïque selon une ou plusieurs des revendications précédentes, **caractérisé en ce que** ladite structure de support et de protection (3) est réalisée, au moins partiellement, en un matériau transparent audit rayonnement lumineux.

4. Panneau photovoltaïque selon une ou plusieurs des revendications précédentes, **caractérisé en ce que** ladite structure de support et de protection (3) est couverte de trous au niveau desdites parties de connexion (302).

5. Panneau photovoltaïque selon une ou plusieurs des revendications précédentes, **caractérisé en ce que** ladite structure de support et de protection (3) comprend une pluralité d'éléments de protection (35) réalisés en un matériau transparent audit rayonnement lumineux, chaque élément de protection étant associé fonctionnellement à un module photovoltaïque respectif (2) au niveau d'une surface (22) dudit module photovoltaïque.

6. Panneau photovoltaïque selon une ou plusieurs des revendications précédentes, **caractérisé en ce que** ladite structure de support et de protection (3) comprend :
- une première couche de protection (31) ;
- une première couche d'encapsulation (32) liée à ladite première couche de protection, ladite première couche d'encapsulation recouvrant lesdits modules photovoltaïques (2) au niveau d'une première surface (21) desdits modules photovoltaïques ;
- une seconde couche de protection (33) liée à ladite première couche d'encapsulation au niveau des parties de connexion (302) de ladite structure de support et de protection, ladite seconde couche de protection comprenant une pluralité d'ouvertures mutuellement espacées (330), chaque ouverture étant positionnée au niveau d'une seconde surface (22) d'un module photovoltaïque respectif, qui est opposée à ladite première surface (21) ;
- une seconde couche d'encapsulation (34) comprenant une pluralité de parties mutuellement espacées (340), chaque partie étant agencée au niveau d'une ouverture respective (330) de ladite seconde couche de protection pour couvrir un module photovoltaïque respectif (2) au niveau de ladite seconde surface (22).

7. Panneau photovoltaïque selon la revendication 6, **caractérisé en ce que** chaque élément de protection (35) est agencé pour recouvrir une partie correspondante (340) de ladite seconde couche d'encapsulation (34) au niveau de la seconde surface (22) d'un module photovoltaïque respectif (2).

8. Panneau photovoltaïque selon une ou plusieurs des revendications précédentes, **caractérisé en ce qu'**il comprend des moyens de connexion mécanique (6) adaptés pour connecter ladite structure de support et de protection (3) à une structure d'installation (100) ou à un panneau photovoltaïque supplémentaire (1B).

9. Installation photovoltaïque **caractérisée en ce qu'**elle comprend un panneau photovoltaïque (1) selon une ou plusieurs des revendications précédentes.

10. Procédé de fabrication d'un panneau photovoltaïque (1) selon une ou plusieurs des revendications 1 à 8, **caractérisé en ce qu'**il comprend l'étape consistant à fournir une structure semi-finie comprenant :
- une première feuille de matériau polymère adaptée pour former une première couche de protection (31) de ladite structure de support et de protection (3) ;
- une deuxième feuille de matériau polymère adaptée pour former une première couche d'encapsulation (32) de ladite structure de support et de protection, ladite deuxième feuille de matériau polymère étant mise en chevauchement avec ladite première feuille de matériau polymère ;
- lesdits modules photovoltaïques (2) mis en chevauchement sur ladite deuxième feuille de matériau polymère au niveau des parties d'encapsulation (301) de ladite structure de support et de protection au niveau d'une première surface (21) desdits modules photovoltaïques ;
- lesdits éléments conducteurs (5) connectés électriquement auxdits modules photovoltaïques mis en chevauchement sur ladite deuxième feuille de matériau polymère ;
- une troisième feuille de matériau polymère adaptée pour former une seconde couche de protection (33) de ladite structure de support et de protection (3), ladite troisième feuille de matériau polymère étant mise en chevauchement sur ladite deuxième feuille de matériau polymère et lesdits éléments conducteurs (5) au niveau des parties de connexion (302) de ladite structure de support et de protection, ladite troisième feuille de matériau polymère ayant des ouvertures (330) au niveau desdits modules photovoltaïques ;
- des quatrièmes feuilles de matériau polymère adaptées pour former des parties correspondantes (340) d'une seconde couche d'encapsulation (34), lesdites quatrièmes feuilles de matériau polymère étant positionnées au niveau d'ouvertures respectives de ladite troisième feuille de matériau polymère et étant mises en chevauchement sur lesdits modules photovoltaïques (2) au niveau d'une seconde surface (22) desdits modules photovoltaïques, qui est opposée à ladite première surface (21) ;
et l'étape consistant à soumettre ladite structure semi-finie à un processus de laminage à chaud.

11. Procédé selon la revendication 10, **caractérisé en ce que** ladite structure semi-finie comprend des éléments de protection (35) en un matériau transparent audit rayonnement lumineux, qui sont mis en chevauchement sur des quatrièmes feuilles respectives de matériau polymère au niveau de modules photovoltaïques respectifs (2).
